(19) Europäisches Patentamt
European Patent Office
Office européen des brevets

(11) **EP 0 945 715 A2**

(12) **EUROPÄISCHE PATENTANMELDUNG**

(43) Veröffentlichungstag:
29.09.1999 Patentblatt 1999/39

(51) Int. Cl.⁶: **G01F 23/284**

(21) Anmeldenummer: 99105431.3

(22) Anmeldetag: 17.03.1999

(84) Benannte Vertragsstaaten:
AT BE CH CY DE DK ES FI FR GB GR IE IT LI LU MC NL PT SE
Benannte Erstreckungsstaaten:
AL LT LV MK RO SI

(30) Priorität: 27.03.1998 DE 19813604

(71) Anmelder:
DaimlerChrysler Aerospace AG
81663 München (DE)

(72) Erfinder:
• Cramer, Stefan
  68623 Lampertheim (DE)
• Gluth, Rolf
  89134 Blaustein (DE)
• Zimmermann, Berthold
  89134 Blaustein (DE)

(54) **Anordnung zur präzisen Entfernungsmessung, insbesondere zur Füllstandsmessung**

(57) Für eine Anordnung zur präzisen Entfernungsmessung insbesondere zur Füllstandsmessung einer Flüssigkeit in einem Tank mittels FMCW-Radar wird vorgeschlagen, die Ausgangsfrequenz eines frequenzvariablen Oszillators in einer Phasenregelschleife an ein Referenzsignal anzubinden und dabei das Referenzsignal digital, vorzugsweise nach dem Prinzip der digitalen Direkt-Synthese DDS aus einem stabilisierten Festfrequenzoszillatorsignal zu gewinnen. Mit der erfindungsgemäßen Anordnung können Entfernungen im Bereich bis zu beispielsweise 50 m mit einer Genauigkeit von einem oder wenigen Millimetern gemessen werden. Für die Anordnung können bei der Erzeugung und Stabilisierung des Oszillatorsignals überwiegend gebräuchliche Bauteile verwandt werden, so daß die Anordnung preisgünstig aufgebaut werden kann.

Fig 2

EP 0 945 715 A2

**Beschreibung**

Die Erfindung betrifft eine Anordnung zur präzisen Entfernungsmessung, insbesondere zur Füllstandsmessung einer Flüssigkeit in einem Tank.

Zur Messung des Füllstands einer Flüssigkeit in einem Tank, insbesondere bei großen Tankanlagen sind neben mechanischen Anordnungen mit Schwimmern insbesondere auch Anordnungen bekannt, bei welchen eine Radaranordnung aus fester Höhe die Leerraumdistanz bis zur Flüssigkeitsoberfläche mißt.

Als Radaranordnungen sind insbesondere FMCW-Radareinrichtungen mit Betriebsfrequenzen im Mikrowellenbereich im Einsatz.

Die Durchstimmung der Betriebsfrequenz der Radareinrichtung erfolgt beispielsweise in äquidistanten Frequenzstufen, die idealerweise einen fein gestuften Treppenverlauf entlang einer linearen Rampe der Betriebsfrequenz über der Zeit bilden. Die Betriebsfrequenz wird typischerweise in einem frequenzvariablen steuerbaren Oszillator, insbesondere einem VCO erzeugt oder durch Frequenzvervielfachung um einen konstanten Faktor aus dem Ausgangssignal eines solchen Oszillators abgeleitet.

Die Ansteuerung des Oszillators erfolgt typischerweise durch einen Digital-Analog-Wandler mit schrittweiser Veränderung der Steuerspannung. Zur Kontrolle der tatsächlichen Oszillatorfrequenz kann das Oszillatorausgangssignal gegebenenfalls nach vorheriger Frequenzteilung, einem Zähler unter Verwendung der konstanten Frequenz eines Festfrequenzoszillators als Frequenznormal zugeführt werden. Bei einer Abweichung der gemessenen Oszillatorfrequenz von der Soll-Frequenz kann die Abstimmspannung des Digital-Analog-Wandlers um einen Korrekturwert nachgeführt werden. Die Korrekturwerte können auch in einer Kalibrierphase bestimmt und bei der Steuerung des Oszillators in Form korrigierter Abstimmspannungen einer nichtlinearen Oszillatorkennlinie bereits berücksichtigt werden.

Die Kalibrierung der Oszillatorkennlinie durch Bestimmung korrigierter Abstimmspannungen an mehreren oder allen Frequenzstufen des Durchstimmbereichs der Oszillatorfrequenz benötigt aufgrund der Frequenzmeßzeit durch den Zähler eine Zeitspanne, die im Regelfall für ausreichend hohe Meßgenauigkeit des Zählers weit über der Dauer einer Durchstimmung des Frequenzbereichs bei der Füllstandsmessung liegt. Da sich die Betriebsbedingungen des Oszillators über der Zeit ändern, muß in kurzen Zeitabständen eine Neukalibrierung vorgenommen werden.

Es zeigt sich ferner, daß der Oszillator nach Vorgabe eines neuen Steuerspannungswerts nicht auf einen neuen konstanten Frequenzwert wechselt, sondern daß sich die Oszillatorfrequenz nach einem schnellen Frequenzsprung auch in dem nachfolgenden Intervall mit konstanter Steuerspannung noch weiter verändert. Diese unerwünschten Frequenzänderungen haben ihre Ursache primär in der Temperaturabhängigkeit der Oszillatorkennlinie. Temperaturschwankungen resultieren hierbei nicht nur aus Änderungen der Umgebungstemperatur, sondern auch und vor allem aus Änderungen der Leistungsaufnahme des Oszillator selbst oder auch benachbarter Schaltkreise. Die Auswirkungen dieser Temperaturänderungen auf einem Halbleitersubstrat oder einer Trägerkeramik haben sehr viel kürzere Zeitkonstanten als die durch Änderung der Umgebungstemperatur bedingten Störungen.

Der Mittelwert der gemessenen Frequenz ist somit nicht identisch mit der tatsächlichen driftenden Oszillatorfrequenz und die Kalibrierung der Oszillatorkennlinie bleibt mit stärkeren Unsicherheiten behaftet als für die gewünschte Meßgenauigkeit mit einer Entfernungsauflösung in der Größenordnung von einem oder wenigen Millimetern zulässig ist. Dieselben Probleme treten auf, wenn anstelle der gestuften Frequenzdurchstimmung eine kontinuierlich zeitlinear ansteigende Frequenzrampe erzeugt werden soll.

Der Erfindung liegt die Aufgabe zugrunde, eine Anordnung zur Entfernungsmessung, insbesondere zur Füllstandsmessung unter Einsatz einer FMCW-Radareinrichtung anzugeben, die eine verbesserte gezielte Einstellung der veränderlichen Betriebsfrequenz und damit eine zuverlässige und präzise Entfernungsmessung gewährleistet.

Die Erfindung ist im Patentanspruch 1 beschrieben. Die Unteransprüche enthalten vorteilhafte Ausgestaltungen und Weiterbildungen der Erfindung.

Die erfindungsgemäße Anordnung erreicht mit geringem Aufwand eine zuverlässig hohe Meßgenauigkeit im Bereich von einem bis wenigen Millimetern bei Meßentfernungen bis ca. 50 m durch Erzeugung einer linearen Frequenzrampe bestimmter Steigung oder exakter Frequenzstufen, die von äußeren Einflüssen wie der Temperatur und Bauteilestreuungen sowie den nicht idealen Eigenschaften des Oszillators weitgehend unabhängig ist. Dabei kann der Sendefrequenzbereich vorteilhafterweise über $10^{10}$ Hz liegen. Die Erfindung kann überwiegend auf Standardbaugruppen der Elektronik, insbesondere der digitalen Elektronik und der Hochfrequenzelektronik zurückgreifen wie beispielsweise DDS-Module und/oder PLL-Module. Für Sondereinsatzfälle diskret aufzubauende und/oder zu implementierende Baugruppen können auf den zur verfügbaren Baugruppen bekannten Kenntnissen aufbauen.

Die bei der Erfindung für eine Anordnung zur Entfernungsmessung, insbesondere Füllstandsmessung vorteilhaft eingesetzte Technik der Erzeugung der FMCW-Radar-Frequenzrampe (kontinuierlich oder in Stufen) macht sich vorteilhaft die im Grunde bekannten Prinzipien der direkten digitalen Frequenzsynthese (digital direkt synthesis, DDS), der sogenannten Fractional-N-Frequenzgeneratoren und/oder der Phasenregelschleifen (phase locked loops, PLL) zunutze und kann im Regelfall hierfür günstig verfügbare fertige Komponenten einsetzen. Eine ausführliche Darstellung der vorstehend genannten Techniken findet sich beispielsweise in den Literaturstellen [1] und [2] der Auflistung am Beschreibungsende.

Da der Phasenregelkreis das Oszillatorausgangssignal auf eine konstante Phasenlage bezüglich des mit hoher Präzision vorliegenden Referenzsignals einregelt, wird zugleich auch der auf Phasenschwankungen des Oszillatorausgangssignals beruhende Rauschanteil des Sendesignals reduziert.

Typischerweise enthält der Phasenregelkreis einen Teiler mit ganzzahligem Teilerverhältnis N, so daß das Oszillatorsignal auf das N-fache des Referenzsignals eingeregelt wird. Die Genauigkeit der Oszillatorfrequenz ist im wesentlichen nur von der Genauigkeit der Referenzfrequenz abhängig. Der nicht lineare Zusammenhang zwischen Abstimmspannung und Oszillatorfrequenz sowie die Temperaturabhängigkeit des Oszillators spielen hierbei keine Rolle. Mit einem Phasenregelkreis ist es möglich, innerhalb sehr kurzer Zeit die Sendefrequenz auf einen bestimmten, durch die Referenzfrequenz und den Teilerfaktor bestimmten Wert einzustellen und gegenüber Veränderungen durch Temperaturschwankungen zu stabilisieren. Wird nun bei einem konstanten Teilerfaktor der Phasenregelschleife die Referenzfrequenz linear oder in definierten vorgebbaren Stufen über der Zeit verändert, so ergibt sich auch für das Oszillatorsignal und das aus diesem direkt oder vorzugsweise nach Frequenzvervielfachung abgeleitete Sendesignal eine besondere lineare Frequenzrampe bzw. eine definierte Stufenfrequenzfolge mit exakten Stufenfrequenzen.

Mit dem Einsatz einer Phasenregelschleife verlagern sich die Linearitätsanforderungen von der direkten Steuerung des Oszillators auf die Erzeugung eines hochgenauen Referenzsignals, das in einem wesentlich niedrigeren Frequenzbereich liegen kann. Das Sendesignal und damit auch das Oszillatorsignal müssen in der Frequenz sehr feinstufig einstellbar sein, so daß die Ableitung des Referenzsignals durch Frequenzteilung aus einem Frequenznormal in dem hier in Frage kommenden Frequenzbereich nicht mit vertretbarem Aufwand realisierbar ist. Wird jedoch vorteilhafterweise ein hoher Teilerfaktor N in der Phasenregelschleife und eine niedrige Referenzfrequenz im Bereich einiger MHz gewählt, so kann das Referenzsignal vorteilhafterweise mit den beschriebenen Techniken digital mit hoher Genauigkeit erzeugt werden.

Die Erfindung ist nachfolgend anhand eines bevorzugten Ausführungsbeispieles unter Bezugnahme auf die Abbildungen noch eingehend veranschaulicht. Dabei zeigt:

Fig. 1 ein Blockschaltbild einer Anordnung aus dem Stand der Technik

Fig. 2 ein Blockschaltbild zu einer erfindungsgemäßen Anordnung

Fig. 3 das Prinzip eines DDS-Frequenzgenerators

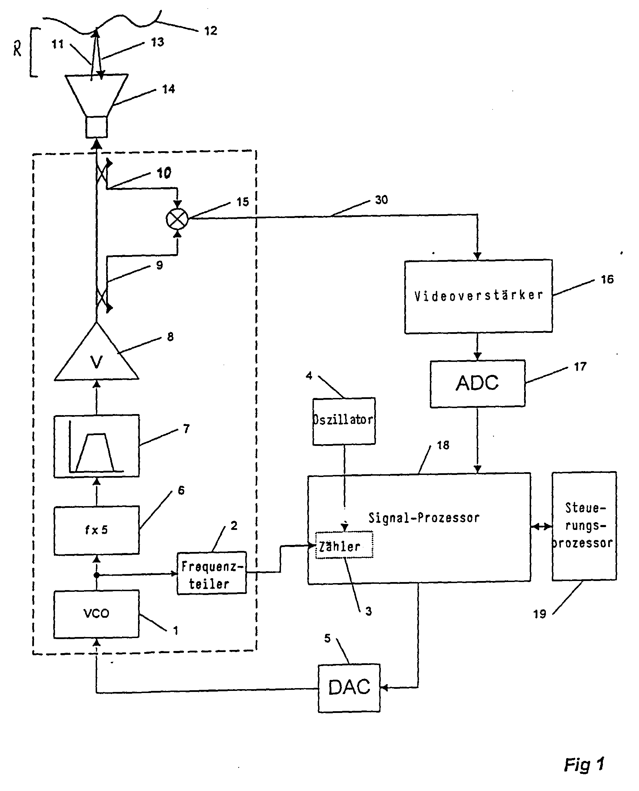

Bei der in Fig. 1 skizzierten Anordnung zur Füllstandmessung mit einer FMCW-Radareinrichtung wird VCO1 in der Sendefrequenz rampenförmig moduliert. Sein Ausgangssignal wird über einen optionalen Frequenzvervielfacher 6 in der Frequenz um einen konstanten Faktor erhöht. In einem Bandpaßfilter 7 werden störende Signalanteile abgetrennt und das störbefreite Signal auf der Betriebsfrequenz wird in einem Sendeverstärker 8 verstärkt und über eine Antenne 14 als Sendesignal 11 in Richtung der Oberfläche 12 einer Flüssigkeit in einem Tank abgestrahlt. Ein Teil des Sendesignales wird nach Durchlaufen des Leerraumes im Abstand R von der Antenne an der Oberfläche des Füllguts reflektiert. Die reflektierte Welle 13 wird über die Antenne 14 empfangen und über einen ersten Richtkoppler 10 einem Mischer 15 zugeführt. Ein geringer Anteil des Sendesignals wird über einen zweiten Richtkoppler 9 ausgekoppelt und dem anderen Eingang des Mischers 15 zugeführt. Durch Überlagerung des reflektierten Signals mit dem Sendesignal und gegebenenfalls weiterer an sich bekannter Verarbeitungsschritte entsteht ein Videosignal 30. Das Videosignal ist eine sinusförmige Schwingung der Frequenz $f_B$, aus der die Entfernung R bestimmt werden kann zu

$$\hat{R} = c/2 \cdot f_B \cdot T/B$$

mit B als Frequenzhub der Frequenzrampe, T als Zeitdauer der Frequenzrampe und c als Lichtgeschwindigkeit.

Eine hohe Meßgenauigkeit im Millimeter-Bereich läßt sich nur bei exakter Kenntnis der Größe B und T und einer möglichst linearen Frequenzrampe der Sendefrequenz erreichen.

Bei der in Fig. 1 skizzierten Anordnung wird die Frequenzrampe durch die Einstellung der Abstimmspannung des VCO1 mit einem Digital-Analog-Wandler 5 in einem vorgegebenen konstanten Zeitraster TA als Frequenzstufenfolge erzeugt. Das Zeitraster wird beispielsweise aus einem Festfrequenzoszillator 4 abgeleitet. Der Zusammenhang zwischen der Abstimmspannung und der Oszillatorfrequenz am Ausgang des VCO kann durch die Messung der Oszillatorfrequenz bestimmt werden. Das Ausgangssignals des VCO wird hierzu einem Frequenzteiler 2 zugeführt und die Frequenz des so erhaltenen Signals in einem Zähler 3 unter Verwendung der Frequenz des Festfrequenzoszillators 4 als Frequenznormal ausgemessen. Der üblicherweise nicht lineare Zusammenhang zwischen der Abstimmspannung und der Sendefrequenz kann dann durch die Ausgabe einer korrigierten Abstimmspannung mit dem Digital-Analog-Wandler 5 linearisiert werden. Die Anordnung weist die bereits beschriebenen Nachteile auf.

Der gesamte Ablauf in der Radareinrichtung wird durch einen Signalprozessor 18 und einen Steuerungsprozessor 19 abgewickelt, wobei das analoge Videosignal 30 gegebenenfalls nach Durchlaufen eines Videoverstärkers 16 und eines Analog-Digital-Wandlers 17 wieder dem Signalprozessor zugeführt sind.

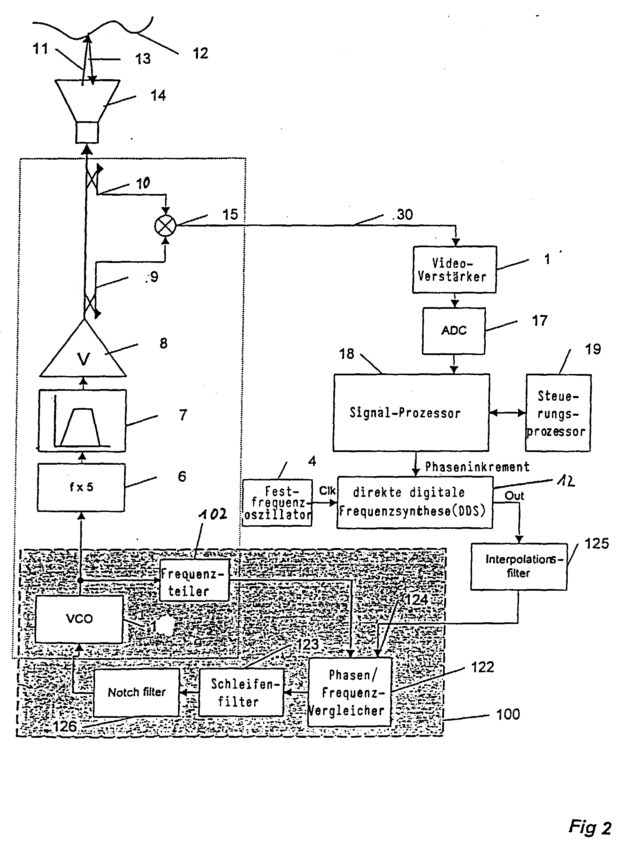

Die in Fig. 2 skizzierte erfindungsgemäße Anordnung arbeitet ebenfalls nach dem Prinzip des FMCW-Radars (oder nach dessen Spezialfall des Stepped-Frequency-Radars mit gestufter Frequenzrampe). Gleichwirkende Baugruppen und Elemente und Signale sind mit gleichen Bezugszeichen wie in Fig. 1 versehen.

Der steuerbare Oszillator 1 ist in diesem Beispiel in eine Frequenzregelschleife 100 eingebunden. Diese enthält einen Frequenzteiler 102 mit hohem Teilerfaktor für das Ausgangssignal des Oszillators 1. Das auf eine wesentlich niedrigere Frequenz heruntergeteilte Oszillatorsignal am Ausgang des Teilers 102 wird einem Phasen/Frequenz-Vergleicher 122 zugeführt, der dieses Signal mit einem Referenzsignal 124 vergleicht und ein von einer festgestellten Phasendifferenz abhängiges Regelsignal abgibt. Das Regelsignal wird über ein Schleifenfilter 123 der PLL und ein optionales Notchfilter 126 als Steuersignal dem Oszillator 1 zugeführt wird.

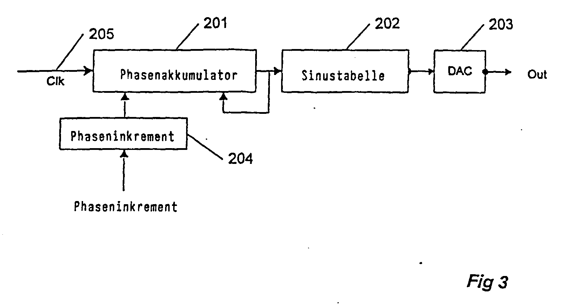

Für eine hohe Frequenzgenauigkeit des Oszillatorsignals ist eine präzise Vorgabe des Referenzsignals von besonderer Bedeutung. Im skizzierten Beispiel wird das Referenzsignal nach dem Prinzip der direkten digitalen Frequenzsynthese DDS erzeugt. Der DDS-Generator ist an sich bekannt und in Fig. 3 noch detaillierter dargestellt. Der DDS-Generator arbeitet nach dem Takt Clk eines frequenzstabilisierten Festfrequenzoszillators 4. Der Signalprozessor gibt ein die Frequenz des Referenzsignals bestimmendes Phaseninkrement als veränderbare Einstellgröße vor. Das Ausgangssignal des DDS-Generators 120 wird über ein Rekonstruktionsfilter (Interpolationsfilter) 125 geführt, dessen Ausgangssignal das Referenzsignal bildet. Die Frequenzstabilität ist nur durch die Stabilität der Taktfrequenz des Festfrequenzoszillators 4 bestimmt. Festfrequenzoszillatoren mit hoher, temperaturkompensierter Frequenzstabilität sind allgemein verfügbar.

Bei dem in Fig. 3 grob skizzierten Prinzip eines DDS-Frequenzgenerators gibt ein Signalprozessor ein Phaseninkrement vor, welches in einem Zwischenspeicher 204 abgelegt wird. Ein Phasenakkumulator erhöht mit jedem Takt eines Taktsignals 205 einen digitalen Phasenwert um das vorgegebene Phaseninkrement. Die Folge der akkumulierten digitalen Phasenwerte adressieren eine Sinustabelle 202, die an ihrem Ausgang den Phasenwerten entsprechende Amplitudenwerte einer Sinusschwingung als Folge von Digitalwerten ausgibt. Diese Folge von digitalen Amplitudenwerten wird in einem Digital-Analog-Wandler 203 als Sinussignal mit durch das Phaseninkrement und die Taktfrequenz Clk bestimmter Frequenz ausgegeben. Eine Veränderung der Frequenz eines solchen Referenzsignals erfolgt durch Vorgabe eines anderen Phaseninkrements ohne Phasensprung.

Die Erfindung ist nicht auf die beschriebenen Beispiele beschränkt, sondern im Rahmen fachmännischen Könnens auf mancherlei Weise abwandelbar.

Literatur

[1] James A. Crawford: "Frequency Synthesizer Design Handbook", Artech House, Boston, 1994.

[2] "Hybrid PLL/DDS Frequency Synthesizers", Qualcomm Application Note, June 1990.

**Patentansprüche**

1. Anordnung zur präzisen Entfernungsmessung, insbesondere zur Füllstandsmessung einer Flüssigkeit in einem Tank mittels einer FMCW-Radareinrichtung in welcher unter Einsatz digitaler Mittel ein frequenzvariabler Oszillator zur Erzeugung einer über einen vorgegebenen Frequenzbereich durchstimmbaren Sendefrequenz angesteuert ist, dadurch gekennzeichnet, daß die digitalen Mittel einen digitalen Frequenzgenerator (120) enthalten, welcher aus einem Festfrequenzoszillatorsignal (Clk) ein Referenzsignal in vorgebbaren Frequenzschritten ableitet, und daß die Frequenz des frequenzvariablen Oszillators unter Anbindung an das Referenzsignal in einer Phasenregelschleife (100) geregelt ist.

2. Anordnung nach Anspruch 1, dadurch gekennzeichnet, daß der digitale Frequenzgenerator ein digitaler Direkt-Frequenzgenerator ist.

3. Anordnung nach Anspruch 1, dadurch gekennzeichnet, daß der digitale Frequenzgenerator ein Fractional-N-Generator ist.

4. Anordnung nach einem der Ansprüche 3, dadurch gekennzeichnet, daß die Sendefrequenz größer als $10^{10}$ Hz ist.

5. Anordnung nach einem der Ansprüche 1 bis 4, dadurch gekennzeichnet, daß die Verweilzeit je Frequenzschritt kleiner als 500 $\mu$s, insbesondere kleiner als 200 $\mu$s ist.

Fig 1

*Fig 2*

205    201                    202            203

Clk → Phasenakkumulator → Sinustabelle → DAC → Out

Phaseninkrement

204

Phaseninkrement

*Fig 3*